# EUROPEAN PATENT APPLICATION

(11) **EP 3 261 119 A1**
(43) Date of publication of application: **27.12.2017**
(21) Application number: 16175368.6
(22) Date of filing: 21.06.2016
(51) Int. Cl.: H01L 23/373, H01L 21/48, H01L 25/07, H01C 1/014, H01C 7/13, H01C 17/06, H01L 23/62

(54) **POWER SEMICONDUCTOR MODULE COMPONENTS AND ADDITIVE MANUFACTURING THEREOF**

(71) Applicant: Infineon Technologies AG, 85579 Neubiberg (DE)
(72) Inventor: Wilke, Ulrich, 59494 Soest (DE); Cordes, Achim, 59581 Warstein (DE); Mücke, Achim, 59597 Erwitte (DE); Tschirbs, Roman, 59494 Soest (DE); Hohlfeld, Olaf, 59581 Warstein (DE)
(74) Representative: Westphal, Mussgnug & Partner Patentanwälte mbB

(57) **Abstract**

A power semiconductor module component comprises a substrate with a first surface and a first layer which is arranged on the first surface of the substrate, wherein at least one of the substrate and the first layer is at least partly manufactured by additive manufacturing.

## Description

### TECHNICAL FIELD

The instant disclosure relates to power semiconductor module components and additive manufacturing thereof.

### BACKGROUND

Components for current power semiconductor modules typically include different layers. The layers may be conducting paths or cooling ribs, for example, and are applied during different procedural steps. The procedural steps may include soldering or welding, for example. Employing a multiplicity of different procedural steps during production of a single power semiconductor module may cause the production to be complex and expensive. Hence, there is a need for a power semiconductor module component with a reduced number of different procedural steps.

### SUMMARY

A power semiconductor module component includes a substrate with a first surface and a first layer which is arranged on the first surface of the substrate, wherein at least one of the substrate and the first layer is at least partly manufactured by additive manufacturing.

A method for producing a power semiconductor module component includes manufacturing a substrate with a first surface and applying a first layer on the first surface of the substrate, wherein at least one of the substrate and the first layer is at least partly manufactured by additive manufacturing.

The power semiconductor modules component and methods for producing the same may be better understood with reference to the following drawings and description. The features in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is an isometric view illustrating a power semiconductor module component.
Figure 2 is an isometric view illustrating a power semiconductor module component with a first metallization.
Figure 3 is an isometric view illustrating a power semiconductor module component with a second or further metallizations and a cooling geometry.
Figure 4 is an isometric view illustrating a power semiconductor module component with semiconductor bodies positioned on the first metallization.
Figure 5 is a sectional view illustrating a power semiconductor module component with a first metallization having solder pad areas recessed above the first metallization.
Figure 6 is an isometric view illustrating a power semiconductor module component with a bush.
Figure 7 is an isometric view illustrating a power semiconductor module component with a lug.
Figure 8 is an isometric view illustrating a power semiconductor module component with an adapted solder resist.
Figure 9 is a sectional view illustrating a power semiconductor module component with an electronic device like a resistor.
Figure 10 is a block diagram illustrating a method for manufacturing a power semiconductor module component with a first layer.
Figure 11 is a block diagram illustrating a method for manufacturing a power semiconductor module component with a first layer and a second layer.

### DETAILED DESCRIPTION

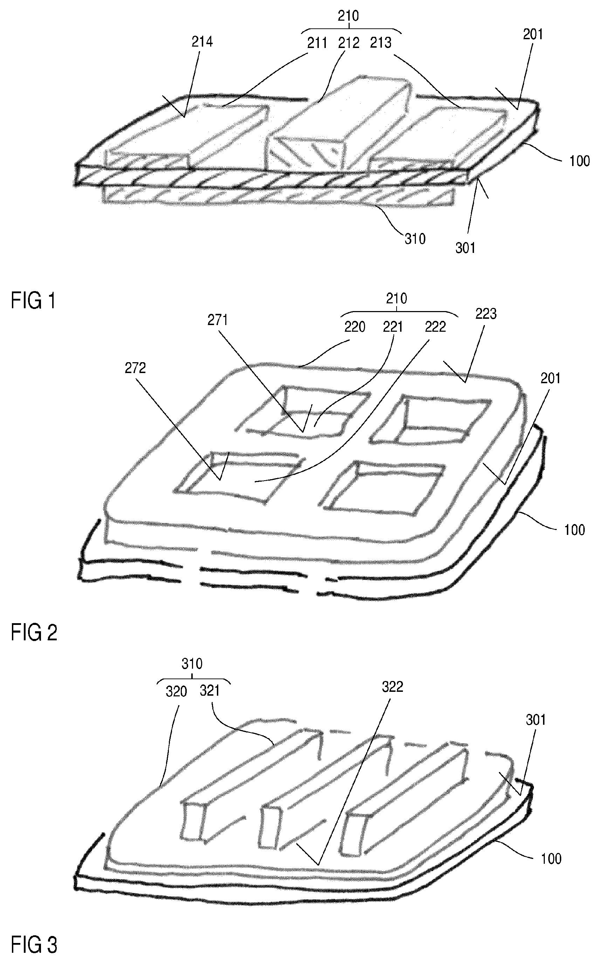

Referring to Figure 1, an exemplary power semiconductor module component includes a substrate 100 with a first surface 201 and a second surface 301 opposite to one another in relation to the substrate 100. A power semiconductor module component may be a part of a power semiconductor or a power semiconductor module in its entirety. The substrate 100 may be a plate made of or including ceramic or metal. The substrate 100 may alternatively be a direct bonded copper substrate, an insulated metal substrate, an active metal brazing substrate or a flexible polyimide substrate.

As shown in Figure 1, the power semiconductor module component further includes at least a first layer 210 that is disposed on the first surface 201 of the substrate 100 and that is at least partly manufactured by additive manufacturing. The first layer 210 may be structured and includes a first conducting path 211, a second conducting path 212 and a third conducting path 213.

Additive manufacturing is understood to be a method used to synthesize three-dimensional objects by forming successive sublayers of material. This method may be controlled by a computer and allows for producing parts in almost any shape or geometry. Data for shape and geometry of the parts may be extracted from a model created with computer aided design. Alternatively, the data may be deduced from a preproduction model which has been scanned by a 3D scanner. For example, additive manufacturing may be selective laser melting, selective electron beam melting, selective laser sintering, stereolithography, digital light processing, multi-jet modeling, laminated object manufacturing or fused deposition modeling or a combination thereof. Additive manufacturing may also be referred to as 3D printing. Materials such as metals, metal alloys, plastics or ceramic may be used in additive manufacturing.

The exemplary conducting paths 211, 212 and 213 in Figure 1 are arranged parallel to one another and may have different thicknesses. The first layer 210 may be any kind of coating or structure which is arranged on the first surface 201 of the substrate 100. The first layer 210 may include several sublayers which may be arranged one above the other or adjacent to each other or both. Further, the first layer 210 may be firmly bonded with the first surface 201 of the substrate 100 and may be at least partly manufactured by additive manufacturing. Various exemplary first layers 210 are described in connection with Figures 1 to 9. The thickness of a conducting path 211, 212 and 213 is defined in the conducting path 211, wherein the thickness is the shortest distance between a first surface 214 of the conducting path 211 and the first surface 201 of the substrate 100.

In the example shown in Figure 1, the second conducting path 212 has a greater thickness than the first conducting path 211 while having the same width, with the effect that the second conducting path 212 may transfer a current with higher strength and/or less ohmic losses. However, the second conducting path 212 does not require a greater area on the first surface 201 of the substrate 100 than the first conducting path 211. One or more of the conducting paths 211, 212 and 213 may be manufactured by conventional manufacturing techniques. The conducting paths 211, 212 and 213 may have a same basic thickness and can be easily manufactured in a single conventional manufacturing step. In order to achieve the increased thickness of conducting path 212, additive manufacturing methods may be used.

Another exemplary power semiconductor module component is illustrated in Figure 2. The first layer 210 may include a first metallization 220 with a first surface 223, wherein the first metallization 220 is an example for a sublayer of the first layer 210. The first surface 223 of the first metallization 220 is the surface opposite to the surface attached to the substrate 100. The first metallization 220 may have one or more integrated solder pad areas 221 and 222. The solder pad areas 221 and 222 may be recessed in the first metallization 220 and may have a rectangular cross section and different depths. The solder pad area 221 may have a bottom surface 271 with a first level and the solder pad area 222 may have a bottom surface 272 with a second level.

In the power semiconductor module component illustrated in Figure 2, the first level of the bottom surface 271 may be achieved by conventional manufacturing methods. Conventional manufacturing methods may be casting, welding, cutting, turning, bonding or swaging. The second level of the bottom surface 272 may be achieved by a conventional manufacturing method in combination with additive manufacturing. The second level of the bottom surface 272 may be higher than the first level of the bottom surface 271. A thickness of the first layer 210 may be achieved by additive manufacturing alone. The solder pad areas 221 and 222 may be configured to accommodate semiconductor bodies 410 and 420. For example, soldering contacts may be arranged in the solder pad areas 221 and 222 for adapting corresponding soldering contacts of the semiconductor bodies 410 and 420. The cross sections of the solder pad areas 221 and 222 parallel to the first metallization 220 may have different thicker shapes realized by additive manufacturing.

Figure 3 illustrates another exemplary power semiconductor module component. In this example, a second layer 310 is disposed on the second surface 301 of the substrate 100. The second layer 310 may be any kind of coating or structure which is arranged on the second surface 301 of the substrate 100 and may include several sublayers which may be arranged one above the other or next to each other or both. The power semiconductor module component may include additional layers which are disposed on the first surface 201 or on the second surface 301 of the substrate 100 and which are at least partly manufactured by additive manufacturing. The second layer 310 may be firmly bonded with the second surface 301 of the substrate 100 and may be at least partly manufactured by additive manufacturing.

In the module shown in Figure 3, the second layer 310 includes at least a second metallization 320 with a first surface 322 and a cooling geometry 321. The cooling geometry 321 may include one or more cooling ribs, wherein the second metallization 320 and the cooling ribs may be sublayers of the second layer 320. The second layer 310 may include further metallizations. The first surface 322 is the surface opposite to the surface attached to the substrate 100. The cooling ribs are arranged on the first surface 322 of the second metallization 320 and may be arranged parallel to one another and may have identical cross sections. As the second metallization 320, the cooling ribs may be at least partly manufactured by additive manufacturing. The cooling ribs allow for enlarging the surface of the power semiconductor module, which is in thermal contact with the ambient atmosphere or liquid cooling fluid. The enlarged surface improves heat dissipation. At least the first layer 210, the second layer 310 or any of the additional layers includes at least partly a conductive or an insulating material.

The cooling ribs may also be arranged on the second surface 301 of the substrate 100 and directly attached thereto. In this case, the second metallization 320 can be omitted.

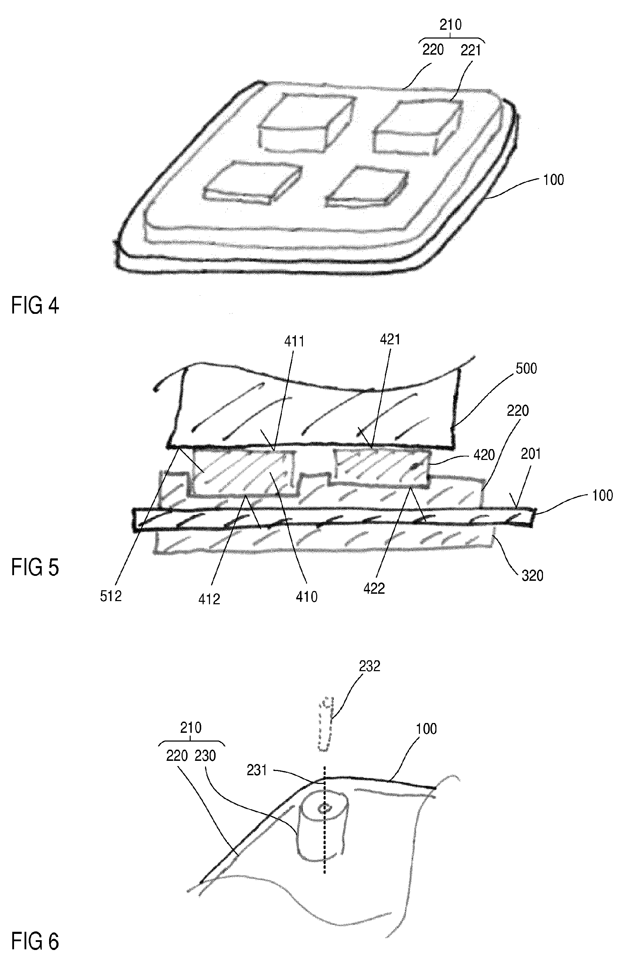

In an exemplary power semiconductor module component shown in Figure 4, the solder pad areas 221 and 222 are at least partly towered above the first metallization 220 or recessed in the first metallization 220. The first metallization 220 may be manufactured by additive manufacturing so that the solder pad areas 221 and 222 may be manufactured in a single fabrication step together with the first metallization 220. The more convenient way is to manufacture a first metallization 220 with homogenous thickness using conventional materials (a direct bonded copper substrate, an insulated metal substrate, an active metal brazing substrate) and adding the solder pad areas 221 and 222 by additive manufacturing methods.

The effect of the solder pad areas 221 and 222 which are recessed in or towered above the first metallization 220 can be seen in Figure 5. The illustrated power semiconductor module component includes the substrate 100 with the first metallization 220 and the semiconductor bodies 410 and 420 which are disposed in the solder pad areas 221 and 222 of the first metallization 220. The semiconductor bodies 410 and 420 include first surfaces 411 and 421 and second surfaces 412 and 422 and are disposed in such way that the first surfaces 411 and 421 of the semiconductor bodies 410 and 420 are in alignment.

A punch 500 may press the semiconductor bodies 410 and 420 into the solder pad areas 221 and 222. The punch 500 may act as a sintering punch which fixes the semiconductor bodies 410 and 420 in place. The punch 500 may fit the semiconductor bodies 410 and 420 in the solder pad areas 221 and 222. As a result of the alignment of the first surfaces 411 and 412 of the semiconductor bodies 410 and 421, a first surface 512 of the punch 500 can be a smooth surface without any indentations.

In an example shown in Figure 6, the power semiconductor module component may additionally include a bush 230 with a longitudinal axis 231. The bush 230 is made of a tube detail with an inner and an outer wall. The cross section of the tube detail may be circular and the longitudinal axis 231 of the bush 230 is perpendicular to the substrate 100. The bush 230 may include a thread which is arranged in the inner wall of the tube section. The inner wall or the thread in the inner wall is configured to join a bolt 232 by pressing or a screw (not shown). For example, the screw may be driven in the thread of the tube section. The bolt 232 of a housing for the power semiconductor module component may be inserted into the bush 230 to fix the housing to the substrate 100. The bolt 232 may also function as an electrical contact, connecting the electrical component to the terminals. In another configuration, a cylindrical inner wall of the tube 230 may also act as a contact zone for electrical contacts that are pressed into the tube section (press-fit contacts with a rigid or flexible contact zone are suitable).

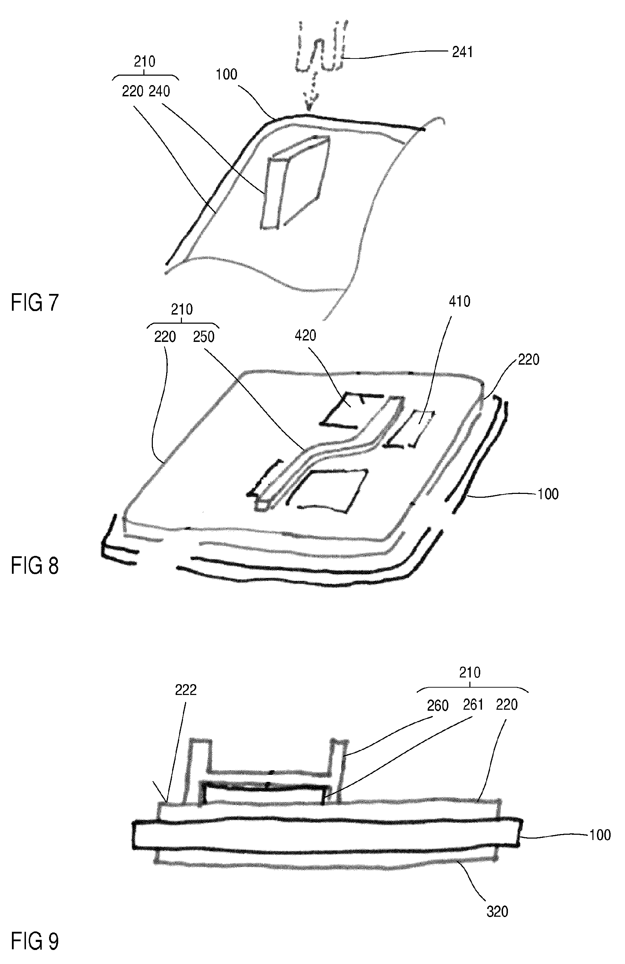

Referring to Figure 7, another exemplary power semiconductor module component includes a lug 240 which is disposed perpendicular to the substrate 100. The lug 240 may be a sheet metal plate which is configured to join a clamp 241. The clamp 241 may be joint with the housing (e.g. as external terminal) and the lug 240 is configured to mesh in the clamp 241. Both the bush 230 and the lug 240 may be arranged on the first surface 223 of the first metallization 220 and may be at least partly manufactured by additive manufacturing. Alternatively, the bush 230 and the lug 240 may be arranged on the substrate 100. The bush 230 and the lug 240 may be configured to provide an electrically conductive connection between the first metallization 220 and the bolt 232 or the clamp 241. For this the bush 230 and the lug 240 may be made of metal. The same holds for the bolt 232 and the clamp 241. As shown in Figure 7, the clamp 241 slips over the lug 240 and is electrically connected with the lug 240.

Referring to Figure 8, another exemplary power semiconductor module component includes a solder resist 250 which is arranged on the first surface 223 of the first metallization 220 and which is manufactured by additive manufacturing, in particular selective laser melting. The solder resist 250 may be made of aluminum or synthetic material. In this example, the solder resist 250 has an S-shape. In other cases the solder resist 250 may have different shapes. The effect of the solder resist 250 is to separate different semiconductor bodies 410 and 420 from each other. The solder resist 250 may constitute a barrier that separates the solder pad areas 221 and 222 for semiconductor bodies 410, 420 from each other. The exemplary power semiconductor module component may include several solder resists 250 which are arranged next to each other.

Another example of a power semiconductor module component is shown in Figure 9. This power semiconductor module component includes the substrate 100, the first metallization 220 with the first surface 223, the second metallization 320 and an electronic device which is arranged on the first surface 223 of the first metallization 220. The electronic device may be a resistor 260. The resistor 260 may be a parallel resistor, e.g. a shunt resistor. The resistor 260 may include an insulator 261 which is arranged between the resistor 260 and the first surface 223 of the first metallization 220. The resistor 260 and the insulator 261 may be attached on the first surface 223 of the first metallization 220 by additive manufacturing.

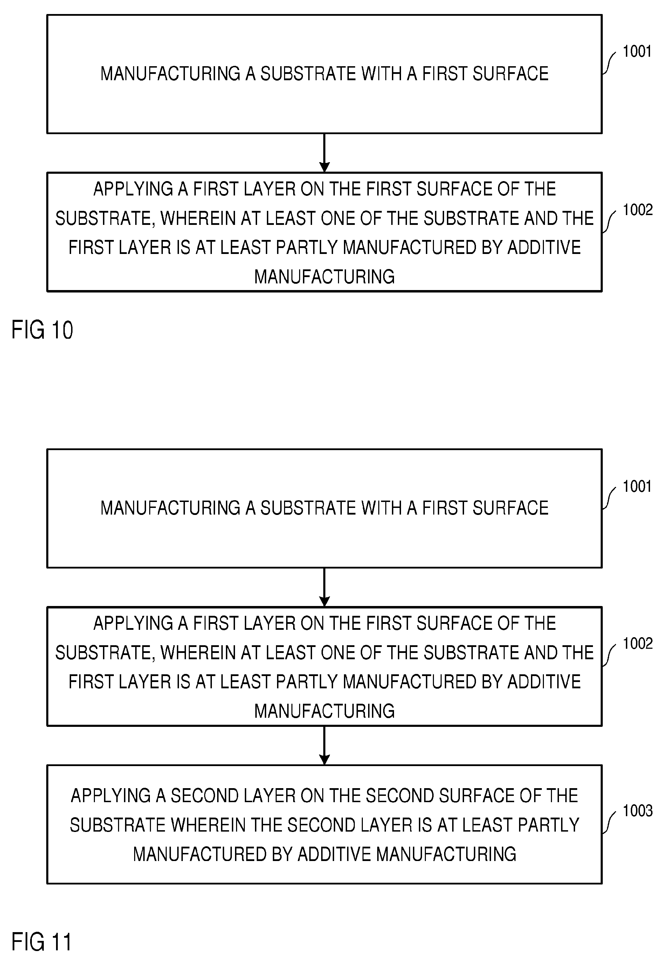

Figure 10 shows an example of a method for manufacturing a power semiconductor module component by additive manufacturing. The method includes the steps of manufacturing 1001 a substrate 100 with a first surface 201 and a second surface 301, applying 1002 a first layer 210 on the first surface 201 of the substrate 100, wherein the substrate 100 or the first layer 210 or both are at least partly manufactured by additive manufacturing. The first layer 210 may include a first metallization 220 and may further include a resistor 260, a bush 230, a lug 240 or a solder resist 250 which is arranged on the first metallization 220. The resistor 260 may also be at least partly created by additive manufacturing. The electrical resistance of the resistor 260 may be determined by the geometry of the manufactured resistor 260.

In addition to the exemplary method described above in connection with Figure 10, a method illustrated in Figure 11 further includes the step of applying 1003 a second layer 310 on the second surface 301 of the substrate 100. In this case, the second layer 310 includes a second metallization 320 which may be at least partly attached by additive manufacturing. The second metallization 320 may be firmly bonded with the substrate 100. A cooling geometry 312 may be applied on the second metallization 320 of the substrate 100. The cooling geometry 312 may be include one or more cooling ribs.

Additive manufacturing may be laser melting, electron beam melting, laser sintering or a combination thereof.

The features mentioned in the single embodiments of the power semiconductor module component may also be combined in different ways. Therefore, features may also be omitted or added in different embodiments of the power semiconductor module component.

The description of embodiments has been presented for purposes of illustration and description. Suitable modifications and variations to the embodiments may be performed in light of the above description or may be acquired from practicing the methods. For example, unless otherwise noted, one or more of the described methods may be performed by a suitable device and/or combination of devices. The described methods and associated actions may also be performed in various orders in addition to the order described in this application, in parallel, and/or simultaneously. The described systems are exemplary in nature, and may include additional elements and/or omit elements.

As used in this application, an element or step recited in the singular and proceeded with the word "a" or "an" should be understood as not excluding plural of said elements or steps, unless such exclusion is stated. Furthermore, references to "one embodiment" or "one example" of the present disclosure are not intended to be interpreted as excluding the existence of additional embodiments that also incorporate the recited features. The terms "first," "second," and "third," etc. are used merely as labels, and are not intended to impose numerical requirements or a particular positional order on their objects.

While various embodiments of the invention have been described, it will be apparent to those of ordinary skilled in the art that many more embodiments and implementations are possible within the scope of the invention. In particular, the skilled person will recognize the interchangeability of various features from different embodiments. Although these techniques and systems have been disclosed in the context of certain embodiments and examples, it will be understood that these techniques and systems may be extended beyond the specifically disclosed embodiments to other embodiments and/or uses and obvious modifications thereof

## Claims

1. A power semiconductor module component comprising:
a substrate (100) with a first surface (201); and
a first layer (210) which is arranged on the first surface (201) of the substrate (100), wherein
at least one of the substrate (100) and the first layer (210) is at least partly manufactured by additive manufacturing.

2. The power semiconductor module component of claim 1, wherein the first layer (210) is structured and comprises one or more conducting paths (211; 212; 213) with different thicknesses.

3. The power semiconductor module component of claim 1 or 2, wherein the first layer (210) comprises a first metallization (220).

4. The power semiconductor module component of claim 3, wherein the first metallization (220) comprises one or more solder pad areas (221; 222) that are configured to accommodate semiconductor bodies (410; 420).

5. The power semiconductor module component of claim 4, wherein the solder pad areas (221; 222) have a rectangular shape.

6. The power semiconductor module component of claim 4 or 5, wherein at least one solder pad area (221; 222) is recessed in or towered above the first metallization (220).

7. The power semiconductor module component of any of claims 4-6, wherein the solder pad areas (221; 222) accommodate semiconductor bodies (410; 420) with first surfaces (411; 421) in the manner that the first surfaces (411; 421) of the semiconductor bodies (410; 420) are in alignment.

8. The power semiconductor module component of any of claims 1-7, wherein the first layer (210) comprises at least one of a bush (230), a lug (240), a cooling geometry (321) and a solder resist (250) and is arranged on a first surface (223) of the first metallization (220).

9. The power semiconductor module component of any of claims 1-8, wherein the first layer (210) comprises a resistor (260) that is arranged on the first surface (223) of the first metallization (220) of the substrate (100).

10. The power semiconductor module component of claim 9, wherein the resistor (260) comprises an insulator (261).

11. The power semiconductor module component of any of claims 1-10, further comprising:
a second layer (310) that is disposed on a second surface (301) of the substrate (100) opposite to the first surface (201) of the substrate (100) and that is at least partly manufactured by additive manufacturing.

12. The power semiconductor module component of claim 11, wherein the second layer (200) comprises a second metallization (320) or further metallizations of the substrate (100).

13. The power semiconductor module component of claim 11 or 12, wherein the second layer (310) comprises a cooling geometry (321) that is disposed on a first surface (322) of the second metallization (320).

14. The power semiconductor module component of any of claims 1-13, wherein additive manufacturing comprises at least one of laser melting, electron beam melting and laser sintering.

15. The power semiconductor module component of any of claims 1-14, wherein the substrate (100) is a direct bonded copper substrate, an insulated metal substrate, an active metal brazing substrate, a ceramic substrate or a polyimide substrate.

16. The power semiconductor module component of any of claims 1-15, further comprising:
additional layers which are disposed on the first surface (201) or on the second surface (301) of the substrate (100) and which are at least partly manufactured by additive manufacturing.

17. The power semiconductor module component of claim 16, wherein at least the first layer (210), the second layer (310) or any of the additional layers includes at least partly a conductive or an insulating material.

18. A method of producing a power semiconductor module component, the method comprising:
manufacturing (1001) a substrate (100) with a first surface (201); and
applying (1002) a first layer (210) on the first surface (201) of the substrate (100), wherein
at least one of the substrate (100) and the first layer (210) is at least partly manufactured by additive manufacturing.

19. The method of claim 18, further comprising:
applying (1003) a second layer (310) on the second surface (301) of the substrate (100), wherein the second layer (310) is at least partly manufactured by additive manufacturing.

20. The method of claim 18 or 19, wherein additive manufacturing includes one of laser melting, electron beam melting and laser sintering.
